# EUROPÄISCHE PATENTANMELDUNG

(11) **EP 1 750 138 A1**
(43) Veröffentlichungstag der Anmeldung: **07.02.2007**
(21) Anmeldenummer: 06012376.7
(22) Anmeldetag: 16.06.2006
(51) Int. Cl.: G01R 31/36

(54) **Vorrichtung zur Überwachung der Ladespannung eines Energiespeichers**

(30) Priorität: 02.08.2005 DE 102005036202
(71) Anmelder: ATLAS ELEKTRONIK GMBH, D-28305 Bremen (DE)
(72) Erfinder: Streiter, Bernd, Dipl.-Ing., 22880 Wedel (DE)

(57) **Zusammenfassung**

Bei einer Vorrichtung zur Überwachung der Ladespannung eines Energiespeichers, insbesondere einer Zelle einer Batterie oder eines Akkumulators, mit einer an dem Energiespeicher (111,112) angeschlossenen Ladungspumpe (12), die dem Energiespeicher (111,112) parallelgeschaltete Kondensatoren (15) und die Kondensatoren (15) zu deren Inreiheschalten miteinander verbindende Schalter sowie einen der Reihenschaltung der Kondensatoren (15) parallelgeschalteten Signalgeber (19) aufweist, sind zur Erfassung sehr kleiner Spannungen ohne eine zusätzliche Stromversorgung die Schalter als elektronische Schalter (18) ausgebildet und Mittel zur galvanisch getrennten Ansteuerung der elektronischen Schalter (18) vorgesehen.

## Beschreibung

Die Erfindung betrifft eine Vorrichtung zur Überwachung der Ladespannung eines Energiespeichers, insbesondere einer Akkumulator- oder Batteriezelle, der im Oberbegriff des Anspruchs 1 angegebenen Gattung.

Batterien und Akkumulatoren sind in der Regel aus einzelnen Energiespeichern, sog. Spannungszellen, zusammengesetzt, die in Reihe geschaltet sind, um eine gegenüber der einzelnen Zellenspannung höhere Batterie- oder Akkumulatorspannung zu erzeugen. Ist eine Zelle früher erschöpft als die übrigen und wird die Batterie oder der Akkumulator weiter belastet, kommt es zur Erwärmung und Gasung der leeren Zelle, wobei die Spannung über der Zelle sich zunächst auf 0 V verringert und schließlich in umgekehrter Richtung wieder steigt. Dieser Vorgang führt dann zur Zerstörung der Zelle oder zur Schädigung der Zellenelektroden. Bei Silberoxid-Zink-Zellen entsteht beispielsweise eine Verzinkung der wiederaufladbaren Silberelektroden, die dann nur mit hohem Aufwand wieder aufbereitet werden können. Auch kann die Erwärmung der leeren Zelle zu einem Brand der Batterie oder des Akkumulators führen.

Um diesen Effekt zu vermeiden, wird bislang in den Zellen eine entsprechend höhere Speicherkapazität vorgehalten, damit die Zellen im Betrieb nicht ihre Kapazitätsgrenze erreichen.

Ein bekannter Spannungsprüfer zum Prüfen einer Spannungsquelle mit niedriger bis mittlerer Spannung (DE 27 42 646 A1) weist einen aus der Reihenschaltung eines Widerstandes und einer Glimmlampe bestehenden Kontrollkreis zur Spannungsprüfung auf. Der Kontrollkreis ist an zwei Ausgangsklemmen einer Ladungspumpe gelegt, die ihrerseits an der Spannungsquelle angeschlossen ist. Die Ladungspumpe besitzt eine Mehrzahl von Kondensatoren, die über die Kontakte eines in einer ersten Schaltstellung sich befindlichen Umschalters parallel zueinander und zur Spannungsquelle geschaltet sind. Der mechanische Umschalter ist so ausgebildet, dass er mittels eines Schaltknopfes in eine zweite Stellung überführbar ist, in welcher seine Kontakte die Kondensatoren in Reihe schalten und von der Spannungsquelle trennen, so dass der Kontrollkreis parallel zu der Reihenschaltung der Kondensatoren liegt. In der ersten Schaltstellung des Umschalters werden die parallelgeschalteten Kondensatoren auf die Spannung der Spannungsquelle aufgeladen. In der zweiten Schaltstellung des Umschalters wird eine um die Anzahl der Kondensatoren höhere Spannung an den Kontrollkreis gelegt. Die Glimmlampe leuchtet solange auf, wie es der Zeitkonstanten der Kondensatoren und des Widerstands im Kontrollkreis entspricht.

Eine bekannte Batterie ist zum Gebrauch mit einem Gerät, das eine Grenzspannung aufweist, bestimmt (DE 699 05 146 T2). Zur Verlängerung der Lebensdauer der Batterie durch reichlichere Ausnutzung der in der Batterie gespeicherten Energie, besitzt die Batterie einen eingebauten Controller, der einen Gleichspannungswandler enthält, der befähigt ist, unterhalb der Grenzspannung typischer elektronischer Geräte zu arbeiten. Der Controller reduziert die Spannung der Batteriezellen und berücksichtigt eine tiefe Entladung der Batterie, um mehr von der gespeicherten Energie zu nutzen. Mittels einer an Masse liegenden Schaltung wird dem Gleichspannungswandler von der Batterie eine Spannung zugeführt, die es ihm ermöglicht, auf seinem Spannungspegel solange zu arbeiten, bis die tatsächliche Zellenspannung der Batterie unterhalb einer Minimalspannung abgesunken ist. Die an Masse liegende Schaltung kann als Ladungspumpe ausgebildet sein.

Ein bekannter Gleichspannungswandler oder DC/DC-Converter (US 4 451 743) setzt eine von einer Batterie abgenommene Spannung in eine Verbraucherspannung um, deren Wert mit einem Faktor, der einen echten Bruch darstellt, multipliziert oder durch diesen Faktor dividiert ist. Der Gleichspannungswandler arbeitet nach dem Prinzip der Kondensatorumladung. Hierzu schaltet eine Mehrzahl von elektronischen Schaltern Hilfskondensatoren einerseits parallel zueinander und in Reihe mit einem Hauptkondensator und andererseits in Reihe miteinander und parallel zu dem Hauptkondensator. Die elektronischen Schalter werden von einem Schaltimpulsgenerator angesteuert.

Eine bekannte Schaltungsanordnung zum Aufladen eines Speicherkondensators auf eine Spannung, die größer ist als eine zur Verfügung stehende Speisespannung (US 4 321 661) weist eine sog. Ladungspumpe aus mehreren Kondensatoren und NMOS-FET's auf, die so geschaltet sind, dass bei einem an die FET's gelegten High-Steuersignal alle Kondensatoren parallel an die Speisespannung gelegt sind und dass bei einem an die FET's gelegten Low-Steuersignal alle Kondensatoren in Reihe geschaltet sind und die Reihenschaltung an dem Speicherkondensator angeschlossen ist.

Der Erfindung liegt die Aufgabe zugrunde, eine Vorrichtung zur Überwachung der Ladespannung eines Energiespeichers, wie er durch eine Batterie- oder Akkumulatorzelle repräsentiert wird, zu schaffen, mit der ohne zusätzliche Spannungsversorgung für den Messvorgang recht kleine Spannungen, z.B. weniger als 0,5 V, sehr genau überwacht bzw. erfasst werden können.

Die Aufgabe ist erfindungsgemäß durch die Merkmale im Anspruch 1 gelöst.

Die erfindungsgemäße Vorrichtung hat den Vorteil, dass nicht nur die Leerlauf- und Nennspannung des Energiespeichers, sondern auch Bruchteile davon erfasst werden und beim Absinken der Ladespannung bei Belastung unter einen noch zulässigen Entladungszustand ein Signal ausgegeben wird, das z.B. als Anzeige oder zum Abschalten der Belastung des Energiespeichers herangezogen werden kann. Damit ist es möglich, den Energiespeicher bis an seine Kapazitätsgrenze zu belasten, ohne dass eine Schädigung eintritt. Eine höhere Kapazität des Energiespeichers muss nicht mehr vorgehalten werden, so dass sich der Wirkungsgrad des Energiespeichers wesentlich verbessert. Durch die galvanisch entkoppelte Ansteuerung der elektronischen Schalter der sog. Ladungspumpe lässt sich die Schalteransteuerung beliebig hoch isolieren, so dass eine recht genaue Messung erfolgt.

Die erfindungsgemäße Vorrichtung hat darüber hinaus den Vorteil, dass sie sehr bauklein ausgeführt werden kann und damit vorteilhaft an dem zu überwachenden Energiespeicher selbst platziert werden kann. Es lassen sich Baugruppen realisieren, die alle Zellen einer eine beliebig hohe Klemmenspannung aufweisenden Batterie gleichzeitig gemeinsam überwachen.

Zweckmäßige Ausführungsformen der erfindungsgemäßen Vorrichtung mit vorteilhaften Weiterbildungen und Ausgestaltungen der Erfindung ergeben sich aus den weiteren Ansprüchen.

Gemäß einer vorteilhaften Ausführungsform der Erfindung ist eine Auswerteeinheit galvanisch getrennt an den Signalgeber angekoppelt. Hierdurch wird das von dem Signalgeber ausgegebene Signal für eine Gutanzeige und/oder zur Anzeige der noch vorhandenen Restspannung des Energiespeichers herangezogen, ohne dass die Messgenauigkeit bei der Spannungsüberwachung beeinträchtigt wird.

Die Erfindung ist anhand eines in der Zeichnung dargestellten Ausführungsbeispiels einer Überwachungsvorrichtung im folgenden näher beschrieben. Es zeigen:
- Fig. 1: ein Blockschaltbild einer Spannungsüberwachungsvorrichtung für einen Energiespeicher,
- Fig. 2: ein Schaltbild einer Ladungspumpe in der Spannungsüberwachungsvorrichtung in Fig. 1,

- Fig. 3 und 4: jeweils ein Schaltbild einer gegenüber Fig. 2 modifizierten Ladungspumpe,
- Fig. 5: ein Diagramm für die Ansteuerung der Ladungspumpe in Fig. 2, 3 oder 4.

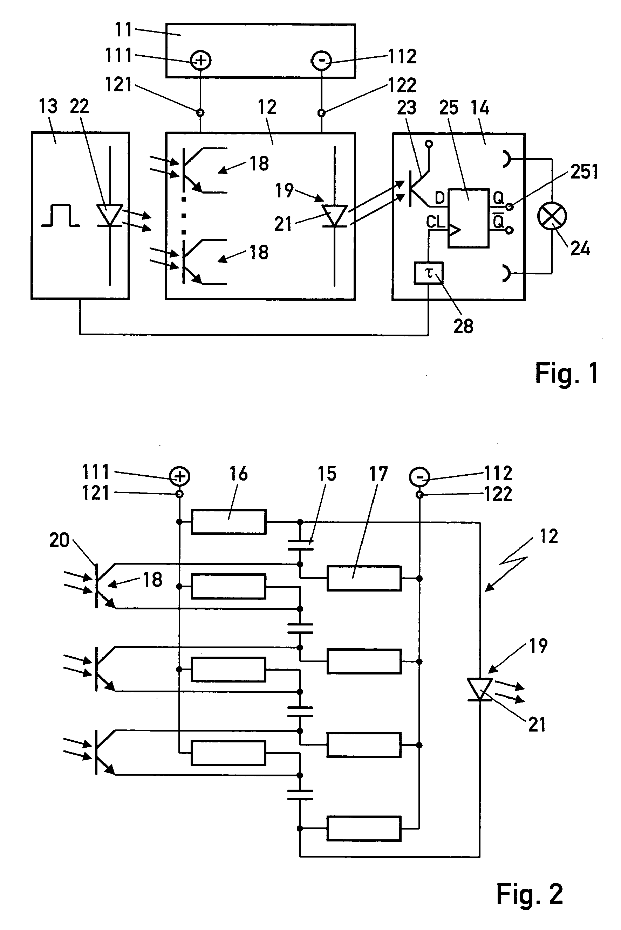

In Fig. 1 ist ein Energiespeicher 11 mit seinen Potentialanschlüssen 121, 122 dargestellt, wobei der Potentialanschluss 121 der Pluspol und der Potentialanschluss 122 der Minuspol ist. Dieser Energiespeicher 11, der beispielsweise eine Zelle einer Batterie oder eines Akkumulators ist, soll daraufhin überwacht werden, dass er nicht unter eine Mindestgrenze entladen wird, d.h. dass seine Ladespannung nicht unter einen minimalen Spannungswert absinkt. Hierzu wird das Verfahren zur Spannungsüberwachung wie folgt durchgeführt:

Mehrere parallelgeschaltete Kondensatoren werden mittels des Energiespeichers 11 aufgeladen. Die aufgeladenen Kondensatoren werden in Reihe geschaltet und die an der Reihenschaltung anstehende Summenspannung mit einer Spannungsschwelle verglichen. Ist die Summenspannung größer als die Spannungsschwelle so wird eine Gutanzeige ausgegeben. Die Zahl der erforderlichen Kondensatoren wird anhand der Spannungsschwelle und einer zur Überwachung vorgegebenen kleinsten Ladespannung des Energiespeichers 11 bestimmt. Beträgt beispielhaft die Spannungsschwelle 1,32 V und werden jeweils vier parallelgeschaltete Kondensatoren aufgeladen, so beträgt die niedrigste Ladespannung des Energiespeichers 11, bei der noch eine Gutanzeige erfolgt, unter Berücksichtigung von Bauelementetoleranzen ca. 0,4 V.

Bei unveränderter Anzahl der Kondensatoren kann diese niedrigste zu überwachende Ladespannung des Energiespeichers 11 angehoben werden, indem die Aufladezeit, respektive die Aufladespannung, der Kondensatoren reduziert wird. Je nach Reduzierung kann dadurch beispielhaft die niedrigste zu überwachende Ladespannung auf 0,6 V oder mehr angehoben werden. Sinkt die Ladespannung des Energiespeichers 11 unter diesen Wert ab, so wird eine Gutanzeige nicht mehr ausgegeben und eine Stromentnahme aus dem Energiespeicher 11 muss abgebrochen werden.

Für eine ständige Überwachung des Ladezustands des Energiespeichers 11 wird das Aufladen der Kondensatoren, das Hintereinanderschalten der Kondensatoren und der Vergleich der aus der Reihenschaltung sich ergebenden Summenspannung mit einer Spannungsschwelle in vorzugsweise periodischen Intervallen wiederholt durchgeführt.

Bevorzugt werden zum Vergleich der Summenspannung mit der Spannungsschwelle die in Reihe geschalteten Kondensatoren über eine Leuchtdiode entladen und das Inreiheschalten oder Hintereinanderschalten der Kondensatoren mit elektronischen Schaltern vorgenommen, die galvanisch entkoppelt geschaltet werden. Als elektronische Schalter werden vorzugsweise elektrooptische Koppelelemente, wie Fototransistoren oder optische FETs verwendet. Gemäß einer Modifizierung des Verfahren wird anstelle eines Kondensators der Energiespeicher selbst in Reihe geschaltet, wodurch Bauelemente eingespart werden und somit der erforderliche Bauraum zur Unterbringung der Spannungsüberwachungsvorrichtung verringert wird.

Das erfindungsgemäße Verfahren wird mittels eines in Fig. 1 dargestellten Ausführungsbeispiels einer Vorrichtung realisiert.

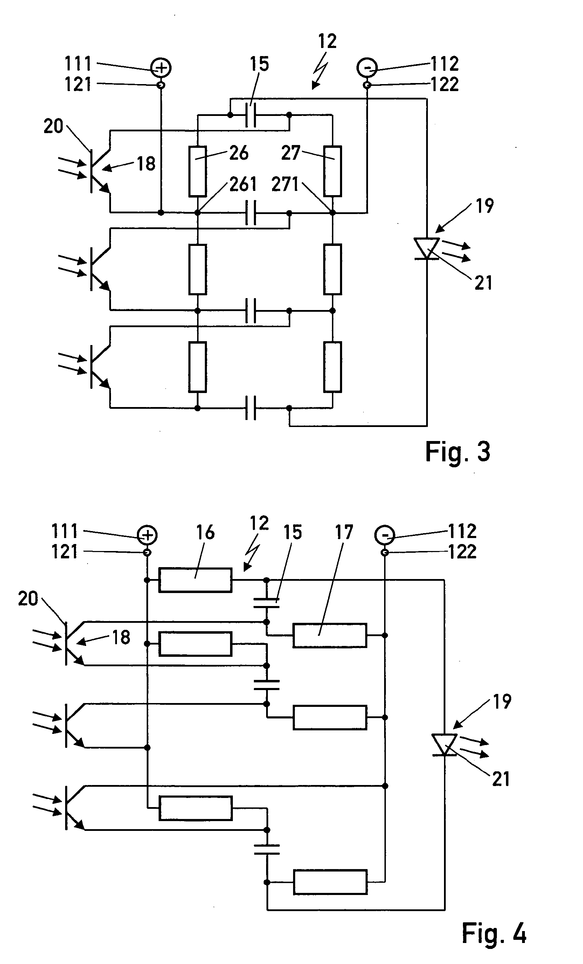

Im Blockschaltbild der Fig. 1 ist die an dem Energiespeicher 11 angeschlossene Vorrichtung zur Spannungsüberwachung im Blockschaltbild dargestellt. Die Vorrichtung umfasst eine galvanisch entkoppelte Ladungspumpe 12, einen Impulsgenerator 13 zur galvanisch entkoppelten Ansteuerung der Ladungspumpe 12 sowie eine galvanisch entkoppelt an der Ladungspumpe 12 angeschlossene Auswerteeinheit 14. Mögliche Schaltungsanordnungen der an den Potentialanschlüssen des Energiespeichers 11 angeschlossenen Ladungspumpe 12 sind in Fig. 2 bis 4 dargestellt. Dabei ist der Eingang 121 der Ladungspumpe 12 mit dem Pluspol 111 des Energiespeichers 11 und der Eingang 122 der Ladungspumpe 12 mit dem Minuspol 112 des Energiespeichers 11 verbunden. Den beiden Eingängen 121, 122 und damit dem Energiespeicher 11 sind mehrere Kondensatoren 15, hier insgesamt vier Kondensatoren 15, parallelgeschaltet. Im Ausführungsbeispiel der Fig. 2 liegt jeder Kondensator 15 über einen ersten Widerstand 16 an dem Eingang 121, also am Pluspol 111 des Energiespeichers 11, und über einen zweiten Widerstand 17 an dem Eingang 122, also an dem Minuspol 112 des Energiespeichers 11. Im Ausführungsbeispiel der Fig. 3 sind gleichartig gepolte Kondensatorplatten über Widerstände 26, 27 miteinander verbunden und einerseits ein ausgewählter Verbindungspunkt 261 der Verbindungspunkte der Widerstände 26 mit dem Eingang 121 und andererseits ein ausgewählter Verbindungspunkt 271 der Verbindungspunkte der Widerstände 27 mit dem Eingang 122 der Ladungspumpe 12 verbunden. Hierbei ergeben sich unterschiedliche Aufladungszeiten der Kondensatoren 15. Die Verbindungspunkte 261 und 271 in jeder Reihe der Widerstände 26 bzw. 27 können beliebig gewählt werden und sind nicht auf die in Fig. 3 ausgewählten Verbindungspunkte festgelegt. Die Kondensatoren 15 sind zur Herstellung der Reihenschaltung über galvanisch getrennt ansteuerbare elektronische Schalter 18 miteinander verbunden, und der Reihenschaltung der Kondensatoren 15 ist ein Signalgeber 19 mit Spannungsschwelle parallelgeschaltet, der ein Signal ausgibt, wenn die Summenspannung der in Reihe geschalteten Kondensatoren 15 die Spannungsschwelle übersteigt. In dem beschriebenen Ausführungsbeispiel sind die elektronischen Schalter 18 als optoelektronische Koppelelemente, z.B. als Fototransistoren 20 oder optischen FETs, ausgebildet. Der Signalgeber 19 ist mit einer Leuchtdiode, kurz LED 21, realisiert. Die Spannungsschwelle des Signalgebers 19 und die Zahl der parallelgeschalteten Kondensatoren 15 in der Ladungspumpe 12 gibt die niedrigste Ladespannung des Energiespeichers 11 vor, die noch überwacht werden kann. Beträgt beispielhaft die Spannungsschwelle 1,32 V (das ist die Mindestspannung, die die LED 21 zum Aufleuchten benötigt), so wird von der Überwachungsvorrichtung eine Restladespannung des Energiespeichers 11 erkannt, die wenig kleiner als 0,4 V ist.

Die elektronischen Schalter 18 werden von dem Impulsgenerator 13 galvanisch entkoppelt geschaltet, wozu bei Ausbildung der elektronischen Schalter 18 als Fototransistoren 20 der Impulsgenerator 13 mittels einer LED 22 Steuerimpulse als Lichtimpulse aussendet. Durch die Lichtimpulse der Leuchtdiode 22 werden die Fototransistoren 20 leitend, so dass nunmehr die während der Sperrphase der Fototransistoren 20 von dem Energiespeicher 11 aufgeladenen Kondensatoren 15 in Reihe geschaltet sind und die Summenspannung der Kondensatoren 15 am Signalgeber 19 bzw. an der LED 21 liegt.

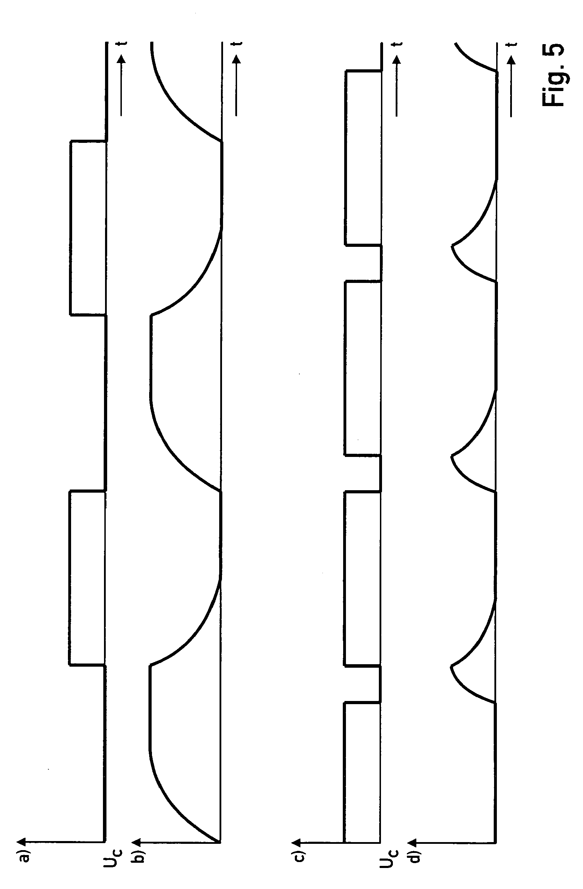

In Fig. 5 zeigt das Diagramm a die Steuerimpulse und Diagramm b die Aufladespannung der Kondensatoren 15. Im Beispiel der Fig. 5, Diagramm a und b, haben die Steuerimpulse ein Tastverhältnis von 1:1, d.h. Impulsdauer und Impulspause sind gleich groß. Während der Impulspausen, in denen die elektronischen Schalter 18 geöffnet sind, werden die Kondensatoren 15 von dem Energiespeicher 11 auf eine maximale Aufladespannung aufgeladen. Während der Impulsdauer, während der die elektronischen Schalter 18 geschlossen sind, werden die Kondensatoren 15 vollständig entladen. Die vollständige Entladung ist nicht zwingend und nur beispielhaft zur Erläuterung der Funktionsweise angenommen. Wird jedoch, wie dies im Diagramm c und d der Fig. 5 dargestellt ist, das Tastverhältnis der Steuerimpulse vergrößert, d.h. die Impulsdauer verkleinert, so werden die Kondensatoren 15 während der Öffnungsphase der elektronischen Schalter 18 nur noch auf eine Teilspannung aufgeladen, so dass die Summenspannung der in Reihe geschalteten Kondensatoren 15 kleiner wird. Dadurch wird bei unveränderter Kondensatorzahl die kleinste Ladespannung des Energiespeichers 11, die noch überwacht werden kann, angehoben.

Die Funktionsweise der Spannungsüberwachungsvorrichtung ist wie folgt:

Durch die Steuerimpulse des Impulsgenerators 13 werden die elektronischen Schalter 18 getaktet geschaltet. Während der Impulspausen laden sich die Kondensatoren 15 auf die aktuelle Ladespannung des Energiespeichers 11 auf. Mit Auftreten eines Impulses werden die Kondensatoren 15 in Reihe geschaltet. Die dadurch sich ergebende Summenspannung der Kondensatoren 15 liegt an der Leuchtdiode 21, die zum Einschalten eine Mindestspannung von beispielsweise 1,32 V benötigt. Ist die Summenspannung an der Reihenschaltung der Kondensatoren 15 größer als die Mindestspannung der Leuchtdiode 21, so leuchtet diese solange auf, bis die Kondensatoren 15 sich soweit entladen haben, dass die Mindestspannung der Leuchtdiode 21 unterschritten ist. Nach Abklingen des Steuerimpulses sind die Kondensatoren 15 weitgehend entladen. Während der nächsten Impulspause werden die Kondensatoren 15 wieder aufgeladen und es wiederholt sich der beschriebene Vorgang.

Das von der Leuchtdiode 21 ausgesandte optische Signal wird von der Auswerteeinheit 14 über ein optoelektronisches Koppelelement 23 erfasst und zu einer vorzugsweise optischen "Gutanzeige" verarbeitet, die beispielsweise durch das Aufleuchten einer Signallampe 24 dargestellt wird. In einem möglichen Ausführungsbeispiel ist hierzu das Ausgangssignal des optoelektronischen Koppelelements 23 auf ein D-Flip-Flop 25 gelegt. Aus dem Impulsgenerator 13 wird ein Signal generiert, dessen Low-High-Flanke mittels eines dem ClockEingang CLK des D-Flip-Flop vorgeschalteten Zeitglieds 29 zur Laufzeitanpassung zeitlich mit dem Ausgangsimpuls des optoelektronischen Koppelelements 23 synchronisiert ist. Mit diesem Signal wird das D-Flip-Flop 25 getaktet. Mit jeder Low-High-Flanke am Clockeingang CLK des D-Flip-Flops 25 wird das High-Signal des optoelektronischen Koppelelements 23 von dem D-Flip-Flop 25 übernommen und führt zu einem High-Signal am Q-Ausgang 251 des D-Flip-Flops 25, das zu einer Gutanzeige, z.B. dem Aufleuchten der Signallampe 24, verarbeitet wird.

Ist die Spannung des Energiespeichers 11 zu gering, so werden die Kondensatoren 15 nicht ausreichend aufgeladen. Somit entfällt der Lichtimpuls der Ladungspumpe 12 und das optoelektronische Koppelelement 23 übergibt ein Low-Signal an das D-Flip-Flop 25. Der Q-Ausgang 251 des D-Flip-Flops 25 gibt ein Low-Signal aus.

Legt man beispielhaft eine Schwellenspannung der LED 21 von 1,32 V zugrunde, so wird dann eine Gutanzeige ausgegeben, solange die aktuelle Ladespannung des Energiespeichers 11 größer als ca. 0,4 V ist. Wird diese Ladespannung unterschritten, so kann die Leuchtdiode 21 nicht mehr eingeschaltet werden, und das Erlöschen der Signallampe 24 zeigt die Tiefstentladung des Energiespeichers 11 an.

Soll bei unverändertem Schaltungsaufbau der Ladungspumpe 12 die kleinste zu überwachende Ladespannung des Energiespeichers 11 angehoben werden, so wird die an die Impulse sich anschließende Impulspause verkürzt, wie dies im Diagramm der Fig. 5c dargestellt ist. Dadurch wird die Phase, in der die elektronischen Schalter 18 geöffnet sind und die Kondensatoren 15 von dem Energiespeicher 11 aufgeladen werden, verkürzt, so dass die während der Öffnungszeit der elektronischen Schalter 18 erreichbare Aufladespannung der Kondensatoren 15 kleiner wird, wie dies im Diagramm der Fig. 5d dargestellt ist. Werden nunmehr mit dem nächsten Steuerimpuls die Kondensatoren 15 in Reihe geschaltet, so ist die Summenspannung der Kondensatoren 15 niedriger, und die Leuchtdiode 21 wird bereits bei einem höherliegenden aktuellen Wert der Ladespannung des Energiespeichers 11 nicht mehr eingeschaltet. Auf diese Weise kann beispielhaft die kleinste zu überwachende Ladespannung des Energiespeichers 11 bei unveränderter Anzahl von Kondensatoren 15 von 0,4 V auf 0,6 V oder höher angehoben werden.

Aus den optischen Signalen der Leuchtdiode 19 kann auch der aktuelle Wert der Ladespannung des Energiespeichers 11 abgeleitet werden. Wie vorstehend ausgeführt ist, leuchtet die Signallampe 24 auf, wenn die Spannung des Energiespeichers 11 größer als die kleinste zu überwachende Spannung ist. Erlischt die Signallampe 24, so ist die Spannung des Energiespeichers 11 kleiner als die kleinste zu überwachende Spannung. Durch Variieren der kleinsten zu überwachenden Ladespannung bzw. der Aufladezeit des Kondensators 15 bzw. der Impulspause des Impulsgenerators 13 und durch Vergleich der kleinsten zu überwachenden Spannung mit dem Zustand der Signallampe 24 kann die aktuelle Ladespannung des Energiespeichers 11 empirisch oder mittels sukzessiver Approximation ermittelt werden.

Die in Fig. 4 dargestellte, modifizierte Schaltungsanordnung der Ladungspumpe 12 unterscheidet sich von den in Fig. 2 und 3 dargestellten und vorstehend beschriebenen Schaltungsanordnungen der Ladungspumpe 12 dadurch, dass anstelle eines Kondensators 15 der Energiespeicher 11 selbst in Reihe mit den übrigen Kondensatoren 15 geschaltet wird. Hierdurch wird eine Bauelementengruppe der Schaltungsanordnung in Fig. 2, bestehend aus zwei Widerständen 16, 17 und einem Kondensator 15, eingespart, was sowohl hinsichtlich der Gestehungskosten als auch des Bauraums von Vorteil ist. Im übrigen ist der Schaltungsaufbau identisch mit dem in Fig. 2, so dass gleiche Bauelemente mit gleichen Bezugszeichen versehen sind. Die Funktionsweisen aller Schaltungsanordnungen in Fig. 2, 3 und 4 für die Ladungspumpe 12 in Fig. 1 sind gleich.

## Patentansprüche

1. Vorrichtung zur Überwachung der Ladespannung eines Energiespeichers, insbesondere einer Zelle einer Batterie oder eines Akkumulators, mit einer an dem Energiespeicher (11) angeschlossenen Ladungspumpe (12), die dem Energiespeicher (11) parallelgeschaltete Kondensatoren (15) und den Kondensatoren (15) zu deren Inreiheschalten miteinander verbindende Schalter sowie einen der Reihenschaltung der Kondensatoren (15) parallelgeschalteten Signalgeber (19) aufweist, der bei einer Eingangsspannung, die größer ist als eine Spannungsschwelle, ein Signal ausgibt, **dadurch gekennzeichnet, dass** die Schalter elektronische Schalter (18) sind und dass Mittel zum galvanisch getrennten Ansteuern der elektronischen Schalter (18) vorgesehen sind.

2. Vorrichtung nach Anspruch 1, **dadurch gekennzeichnet, dass** die Mittel zum galvanisch getrennten Ansteuern der elektronischen Schalter (18) einen Steuerimpulse erzeugenden Impulsgenerator (13) aufweisen.

3. Vorrichtung nach Anspruch 2, **dadurch gekennzeichnet, dass** die Impulspausen zwischen den Steuerimpulsen entsprechend einer gewünschten maximalen Aufladespannung oder einer gewünschten Aufladezeit der Kondensatoren (15) variierbar sind.

4. Vorrichtung nach Anspruch 2 oder 3, **dadurch gekennzeichnet, dass** die elektronischen Schalter (18) optoelektronische Koppelelemente, vorzugsweise Fototransistoren (20) oder optische FETs, und die Steuerimpulse vorzugsweise mittels einer Leuchtdiode (22) abgestrahlte Lichtimpulse sind.

5. Vorrichtung nach einem der Ansprüche 1 bis 4, **dadurch gekennzeichnet, dass** die Zahl der Kondensatoren (15) durch die Spannungsschwelle und die zu überwachende niedrigste Ladespannung des Energiespeichers (11) bestimmt ist.

6. Vorrichtung nach einem der Ansprüche 1 bis 5, **dadurch gekennzeichnet, dass** anstelle eines der Kondensatoren (15) der Energiespeicher (11) selbst in Reihe mit den übrigen Kondensatoren (15) schaltbar ist.

7. Vorrichtung nach einem der Ansprüche 1 bis 6, **dadurch gekennzeichnet, dass** die Aufladezeit oder die Aufladespannung der Kondensatoren (15) durch zeitliche Ansteuerung der elektronischen Schalter (18) einstellbar ist.

8. Vorrichtung nach einem der Ansprüche 1 bis 7, **gekennzeichnet durch** eine galvanisch getrennt an den Signalgeber (19) angekoppelte Auswerteeinheit (14), die mit dem Signal des Signalgebers (19) eine Gutanzeige generiert und/oder aus dem Signal des Signalgebers (19) die aktuelle Ladespannung des Energiespeichers (11) bestimmt.

9. Vorrichtung nach Anspruch 8, **dadurch gekennzeichnet, dass** der Signalgeber (19) eine Leuchtdiode (21) ist und die galvanisch getrennte Ankopplung der Auswerteeinheit (14) mittels eines optoelektronischen Koppelelements (23) vorgenommen ist.
